# EUROPÄISCHE PATENTSCHRIFT

(11) **EP 0 741 804 B1**
(45) Veröffentlichungstag und Bekanntmachung des Hinweises auf die Patenterteilung: **28.10.1998**
(21) Anmeldenummer: 95907549.0
(22) Anmeldetag: 30.01.1995
(51) Int. Cl.: C25D 5/06, C25D 17/14

(54) **VERFAHREN UND VORRICHTUNG ZUM ELEKTROLYTISCHEN METALLISIEREN ODER ÄTZEN VON BEHANDLUNGSGUT**
PROCESS AND DEVICE FOR THE ELECTROLYTIC METAL COATING OR ETCHING OF ARTICLES
PROCEDE ET DISPOSITIF DE METALLISATION OU D'ATTAQUE ELECTROLYTIQUES D'ARTICLES A TRAITER

(30) Priorität: 28.01.1994 DE 4402596
(43) Veröffentlichungstag der Anmeldung: 13.11.1996
(73) Patentinhaber: ATOTECH Deutschland GmbH, 10553 Berlin (DE)
(72) Erfinder: SCHNEIDER, Reinhard, D-90556 Cadolzburg (DE)
(74) Vertreter: Effert, Udo, Dipl.-Ing.
(86) Internationale Anmeldenummer: DE9500134
(87) Internationale Veröffentlichungsnummer: WO9520692

(56) Entgegenhaltungen:
- GB-A- 176 064
- US-A- 2 540 602
- US-A- 4 661 213

## Beschreibung

Die Erfindung betrifft ein Verfahren und eine Vorrichtung zum elektrolytischen Metallisieren oder Ätzen von Behandlungsgut.

Die Wirtschaftlichkeit elektrolytischer Metallisier- und Ätzverfahren hängt entscheidend von der maximalen Stromdichte ab, mit der noch ein technisch brauchbares Behandlungsergebnis erhalten werden kann. Die maximale Stromdichte ist vor allem davon abhängig, mit welcher Geschwindigkeit frisches Behandlungsmittel (Elektrolytlösung) an die Oberfläche des Behandlungsgutes gelangen kann. Beim elektrolytischen Metallisieren werden in unmittelbarer Nähe der Oberfläche des Behandlungsgutes die abgeschiedenen Metallionen verbraucht. Dadurch sinkt die Metallisierungsgeschwindigkeit, und der Prozeß verlangsamt sich. Dasselbe gilt auch für andere elektrolytische Behandlungsverfahren, beispielsweise das elektrolytische Ätzen.

Zur Abhilfe kann frische Behandlungslösung durch Flutrohre, die beim elektrolytischen Metallisieren zwischen Anode und dem Behandlungsgut (Kathode) angeordnet sind, kontinuierlich an die Oberfläche des Behandlungsgutes herangeführt werden. Dieser Verfahrensweise sind jedoch strömungstechnische Grenzen gesetzt; der Flüssigkeitsaustausch in der unmittelbaren Nähe der Oberfläche des Behandlungsgutes (Diffusionsschicht) kann nur in begrenztem Umfange erhöht werden. Außerdem ist eine derartige Verfahrensweise auch nachteilig, da die zwischen den Anoden und dem Behandlungsgut angeordneten Flutrohre das elektrische Feld zwischen den Anoden und Kathoden abblenden, so daß sich Metall ungleichmäßig auf dem Behandlungsgut niederschlägt. Dieser Nachteil wirkt sich insbesondere dann stark aus, wenn der Abstand der Flutrohre zur Oberfläche des Behandlungsgutes klein ist. Andererseits wäre aus strömungstechnischen Gründen ein kleiner Abstand der Flutrohre zur Oberfläche des Behandlungsgutes vorzuziehen, um eine gezielte Anströmung und damit eine möglichst große Stromdichte zu erreichen. In diesem Falle würden sich an einigen Stellen auf der Oberfläche des Behandlungsgutes hohe Stromdichten einstellen, so daß die den elektrolytischen Metallisierungsbädern üblicherweise zugegebenen Zusätze an diesen Stellen oxidiert werden.

Plattenförmiges Behandlungsgut, insbesondere Leiterplatten, wird bevorzugt in horizontalen Behandlungsanlagen bearbeitet. Das Behandlungsgut wird in horizontaler Lage erfaßt und in horizontaler Richtung durch die Anlage hindurchgeführt und dabei elektrolytisch behandelt. In derartigen Anlagen werden üblicherweise Rollen für den Transport und die Führung des Behandlungsgutes verwendet. Auch diese befinden sich im Bereich zwischen Anode und Kathode. Insbesondere für sehr dünne Folien sind ferner Führungselemente für deren einwandfreien Transport erforderlich, um ein Abgleiten der Folien aus der Transportbahn heraus und ein Umwickeln der Folien um die Transportrollen zu verhindern. Auch derartige Konstruktionselemente behindern ebenso wie die erwähnten Transportrollen den Stromfluß zwischen der Anode und dem Behandlungsgut.

Für die elektrolytische Metallisierung werden üblicherweise aus dem abzuscheidenden Metall hergestellte lösliche Anoden verwendet. Deren Positionierung innerhalb der Metallisierungsanlage sowie deren übliche Form und Größe bereiten erhebliche Schwierigkeiten, einfache konstruktive Lösungen zur Verhinderung der genannten Probleme zu finden. Bei der Verwendung von unlöslichen Anoden besteht in Horizontalanlagen dagegen die Möglichkeit, diese langgestreckt auszubilden und so anzuordnen, daß die beschriebenen Abblendungen nicht auftreten. Beispielsweise können bei derartigen Anordnungen in wiederholter Folge nebeneinander unlösliche Anoden, mindestens ein Flutrohr für die Zuführung frischen Behandlungsmittels zu der Oberfläche des Behandlungsgutes und Transportrollen angeordnet werden. Die Positionierung dieser einzelnen Elemente wird so gewählt, daß das Behandlungsgut während des Metallisierungsvorganges langsam an ihnen vorbeigeführt wird. Die Länge einer derartigen Anlage wird von den geometrischen Abmessungen der drei Elemente und ihrer erforderlichen Abstände voneinander, sowie von deren Gesamtanzahl bestimmt. Derartige Behandlungsanlagen sind daher sehr lang und relativ teuer.

In der deutschen Offenlegungsschrift 36 03 856 wird ein Verfahren zur kontinuierlichen Galvanisierung von ebenen Werkstücken, wie Leiterplatten, beschrieben, bei dem die Werkstücke horizontal durch eine Galvanisieranlage hindurchgeführt und innerhalb der Galvanisieranlage von einem kathodisch geschalteten, rotierenden Walzenpaar erfaßt und transportiert werden und bei dem die Elektrolytlösung von einem sich in der Nachbarschaft des kathodischen Walzenpaares befindlichen ebenfalls rotierenden, anodisch geschalteten Walzenpaar, dessen Oberfläche Flüssigkeit aufzunehmen vermag und in geringem Abstand von der Werkstückoberfläche rotiert, auf das Werkstück übertragen wird, so daß die elektrochemische Metallabscheidung in dem Spalt zwischen Werkstückoberfläche und der Oberfläche des anodisch geschalteten Walzenpaares erfolgt. Die Elektrolytlösung wird in diesem Fall aus Anspritzregistern über die Anodenwalzen gesprüht, so daß die Oberfläche des Behandlungsgutes immer mit angereicherter Elektrolytlösung versorgt wird. Durch die schnelle Rotation der Walzen wird die Lösung jedoch in alle Richtungen geschleudert und von den Kunststoffabschirmungen, die sich über den Anspritzregistern und den Anodenwalzen befinden, aufgehalten. Es werden zwar große Mengen der Elektrolytlösung in den Arbeitsbereich gefördert. Jedoch gelangt nur ein geringer Teil davon an den Ort der Behandlungsstelle mit der größten Stromdichte. Dieser liegt zwischen der Anodenwalze und der Oberfläche des Behandlungsgutes. Eine gezielte Anströmung dieser Stelle ist nicht möglich.

Bei walzenförmigen Anoden stellt sich die größte Stromdichte in der Nähe der dem Behandlungsgut am nächsten liegenden Mantellinie der Anode ein. Senkrecht zu beiden Seiten der Mantellinie nimmt sie schnell ab. Dies führt dazu, daß die Galvanisiergeschwindigkeit, in Richtung des Transportweges gesehen, stark schwankt. Um eine ausreichende mittlere Stromdichte auf dem gesamten Behandlungsweg zu erreichen, muß daher die maximale Stromdichte unter der Mantellinie der Anode groß sein. Dies erfordert einen gezielten und wirksamen Elektrolytaustausch an der dortigen Diffusionsschicht, der mit dem vorgenannten Verfahren nicht realisierbar ist.

Weiterhin ist es in diesem Falle nachteilig, daß an den Orten höchster Stromdichte Gase wie Wasserstoff, Sauerstoff und Chlor gebildet werden. Diese Gase greifen den Anodenwerkstoff an. Daher muß dieser mit Edelmetallüberzügen versehen werden, um dessen Korrosion zu begrenzen. Die Gase müssen überdies durch eine zusätzliche Anströmung der Anoden mit Elektrolytlösung abgeführt werden. Dies erfordert weiteren anlagentechnischen Aufwand.

In der Druckschrift EP 0 210 072 A1 wird eine Vorrichtung mit rotierender Metallisierbürste zum selektiven Metallisieren von Metallteilen beschrieben, bei dem eine walzenförmige, mit porösem hydrophobem Material umgebene Anode als Gegenelektrode für die zu beschichtenden Metallteile dient, wobei die Metallteile längs streifend an der Mantellinie der Anode entlanggeführt werden und dabei Elektrolytlösung aus dem Inneren der Anode durch das hydrophobe Material an die Metallteile geströmt wird.

In dem Aufsatz " Elektrolytische Hochleistungsverzinkung von Stahlband durch mechanische Grenzschichtbeeinflussung" von B. Meuthen und D. Wolfhard in der Fachzeitschrift "Metalloberfläche", Band 36 (1982), Seiten 70 - 75 wird ein Verfahren zur Hochleistungsverzinkung von Stahlband beschrieben.

Die dargestellte Laboranlage umfaßt eine kathodisch geschaltete, kreisförmige Blechscheibe, die rotierend an einer durchbohrten Anode entlanggeführt wird, wobei an der Anode befestigtes Faservlies während der Drehung der Kathode auf deren Oberfläche gewischt wird. Durch die Anode wird fortwährend frische Elektrolytlösung an die kathodische Blechscheibe gefördert.

In US-A-46 61 213 ist ein Verfahren zum elektrolytischen Abscheiden von Metallen beschrieben, bei dem eine als Rolle ausgebildete Elektrode die zu behandelnden metallischen Gegenstände wischend berührt. Die Elektrode ist hohl, so daß durch diese der Elektrolyt hindurchgepumpt und durch eine die Elektrode umgebende Manschette auf die Oberfläche des Gegenstandes gefördert werden kann.

Die letztgenannten Dokumente offenbaren Verfahren und Vorrichtungen, bei denen die Oberfläche des Behandlungsgutes gewischt wird, um diese fortwährend mit frischer Elektrolytlösung zu versorgen und dabei die Diffusionsschicht so dünn wie möglich zu halten. Es zeigt sich jedoch, daß die Oberfläche des Behandlungsgutes durch Wischen leicht beschädigt werden kann. Nur durch die Verwendung sehr weicher Werkstoffe als Überzug auf den Wischelektroden wird eine Beschädigung vermieden. Andererseits unterliegt der weiche Überzug, insbesondere bei mit Bohrungen versehenen plattenförmigen Werkstücken, die scharfe Kanten aufweisen, einem verstärkten Abrieb, so daß feinste Abriebpartikel in die Elektrolytlösung gelangen. Die Partikel werden über den Elektrolytkreislauf erneut an die zu behandelnde Oberfläche transportiert und führen dort zu Störungen. Diese können die Metallabscheidung insbesondere in kleinen Löchern von Leiterplatten behindern, da sie sich dort festsetzen. Es hat sich gezeigt, daß die entstehenden Qualitätsmängel auch durch aufwendige zusätzliche Filtersysteme nicht behoben werden können.

In US-A-25 40 602 ist ein weiteres Verfahren offenbart, bei dem metallische Oberflächen, in vorliegenden Fall Aluminiumplatten, mittels geeignet ausgebildeter Elektroden berührt und dabei elektrolytisch behandelt werden. Als Elektroden werden zylindrische rotierende Rohre eingesetzt, die quer zu den horizontal geführten Platten angeordnet sind. Die Elektroden sind hohl und weisen Öffnungen auf, durch die der Elektrolyt in ein die Elektrode ummantelndes Polster und dann auf die Platte strömt.

Der vorliegenden Erfindung liegt von daher das Problem zugrunde, ein Verfahren und eine Vorrichtung zum elektrolytischen Metallisieren oder Ätzen von Behandlungsgut mit hoher Stromdichte zu finden, bei dem die genannten Nachteile des Standes der Technik nicht in Erscheinung treten.

Das Problem wird durch die Ansprüche 1 und 6 gelöst. Bevorzugte Ausführungsformen der Erfindung sind in den Unteransprüchen angegeben.

Ein elektrolytisches Behandlungsverfahren mit hoher Stromdichte, das kostengünstig durchführt werden kann, besteht gemäß der Erfindung darin,
- das Behandlungsgut und Elektroden mit einem Behandlungsmittel in Kontakt zu bringen und die Elektroden gegenüber dem Behandlungsgut elektrisch zu polarisieren,
- das Behandlungsgut linear und die Elektroden drehend zu bewegen und den teils hohlen Elektroden Behandlungsmittel zuzuführen,
- das Behandlungsmittel aus den Oberflächen des Behandlungsgutes gegenüberliegenden Öffnungen in den Elektroden im wesentlichen senkrecht und gezielt gegen die Oberflächen des Behandlungsgutes zu fördern oder in die Öffnungen hineinzusaugen und
- die Drehgeschwindigkeit und -richtung der Elektroden so einzustellen, daß die Außenseiten der Elektroden zu den Oberflächen des Behandlungsgutes synchron bewegt werden.

Dadurch, daß die Elektroden gegenüber dem Behandlungsgut polarisiert werden und daher dazu dienen, das für die elektrolytische Behandlung erforderliche elektrische Feld zu erzeugen und zum anderen die zusätzliche Aufgabe übernehmen, fortwährend frisches Behandlungsmittel an die Oberfläche des Behandlungsgutes zu transportieren, ist eine sehr einfache Anlagenkonfiguration möglich.

Werden weniger gut elektrisch leitende Elektrodenwerkstoffe verwendet, wie beispielsweise Edelstahl, so ist wegen der hohen Stromdichten üblicherweise mit hohen Verlustleistungen zu rechnen, so daß sich die metallischen Teile schnell erwärmen können. Durch die Drehung der Elektroden und durch die intensive Zirkulation des Behandlungsmittels in der unmittelbaren Nähe der Elektroden verteilt sich die entstehende Wärme jedoch auf die gesamte Elektrode und wird zudem schnell in die Elektrolytlösung abgeführt.

Eine Beschädigung der Oberfläche des Behandlungsgutes wie bei den bekannten Wischverfahren ist mit dem erfindungsgemäßen Verfahren nicht möglich, da die Drehgeschwindigkeit und -richtung der Elektroden so eingestellt werden, daß die Außenseiten der Elektroden zu den Oberflächen des Behandlungsgutes synchron bewegt werden.

Durch Anströmung der Oberfläche des Behandlungsgutes mit dem Behandlungsmittel mit hoher Strömungsgeschwindigkeit werden die entstehenden Gase, wie beispielsweise Wasserstoff, Sauerstoff und Chlor, schnell weggeführt.

In einer bevorzugten Ausführungsform der Erfindung übernehmen die Elektroden ferner die Aufgabe des Transportes und der Führung des Behandlungsgutes durch die Behandlungsanlage, indem sie mit den Oberflächen des Behandlungsgutes direkt in Kontakt gebracht werden. Dadurch ist es möglich, das Behandlungsgut mittels der in Drehung versetzten Elektroden durch die Behandlungsanlage hindurchzutransportieren.

Durch die genannten Maßnahmen ist eine sehr kurze kompakte Vorrichtung - realisierbar, da mehrere, den Stromfluß erzeugende Elektroden, unmittelbar nebeneinander und dem Behandlungsgut direkt gegenüberliegend angeordnet werden können. Es ist nicht erforderlich, wie in Anlagen herkömmlicher Bauart die dem Behandlungsgut gegenüberliegenden Elektroden in größerem Abstand voneinander anzuordnen, um dazwischen Führungs- und Transportvorrichtungen vorzusehen und gegebenenfalls auch Anströmvorrichtungen. Dadurch wird auch erreicht, daß die Stromdichte an der Oberfläche des Behandlungsgutes nur im geringem Maße schwankt und zwischen den Elektroden nicht auf Werte nahe Null absinkt.

Die Anordnung bietet auch den Vorteil, daß zwischen den Elektroden und dem Behandlungsgut keine Vorrichtungen zum Tansportieren und Führen sowie zum Anströmen des Behandlungsgutes angeordnet werden müssen, die die Feldlinien zwischen Anode und Kathode abblenden könnten.

Erfindungsgemäß wird das Behandlungsmittel nahezu senkrecht gegen die Oberflächen der Leiterplatten gefördert. Dadurch gelangt das Behandlungsmittel genau an den Ort, an dem die Stromdichte auf der Oberfläche des Behandlungsgutes am größten ist, so daß an dieser Stelle mit dem größten Stoffumsatz eine wirksame Erneuerung des verbrauchten Behandlungsmittels stattfindet. Außerdem wird dadurch die Dicke der Diffusionsschicht verringert, so daß der Transport frischen Behandlungsmittels an die Oberfläche des Behandlungsgutes ebenfalls verbessert wird. Sowohl die Außenseiten der Leiterplatten als auch die Wände der Löcher werden stets mit frischem Behandlungsmittel versorgt. Durch die senkrechte Anströmung des Behandlungsgutes wird das Behandlungsmittel zudem unter Druck durch die Löcher hindurchgefördert, so daß auch bei feinen Löchern eine wirksame Durchströmung ermöglicht wird.

Das Behandlungsmittel kann entweder dadurch an die Oberflächen des Behandlungsgutes gefördert werden, daß das Behandlungsmittel aus Öffnungen in den hohlen Elektroden herausgefördert wird. Eine andere Möglichkeit besteht darin, das Behandlungsmittel in die Öffnungen in den Elektroden hineinzusaugen, so daß es mit hoher Geschwindigkeit aus dem Umgebungsraum zu der den Saugöffnungen gegenüberliegenden Stellen auf der Oberfläche des Behandlungsgutes gefördert wird. In diesem Fall müssen sich das Behandlungsgut und eine Saugelektrode innerhalb des Behandlungsmittels befinden, da andernfalls keine wirksame Anströmung der Behandlungsstelle möglich wäre.

Eine Kombination von Elektroden, aus denen Behandlungsmittel aus geeigneten Öffnungen an die Oberfläche des Behandlungsgutes gefördert wird (Flutelektroden) und weiteren Elektroden, in die das Behandlungsmittel durch geeignete Öffnungen hineingesaugt wird (Saugelektroden), ist eine weitere bevorzugte Ausführungsform der Erfindung. Beispielsweise kann die Durchströmung der Löcher im Behandlungsgut durch Anströmen mittels auf der einen Seite des Behandlungsgutes angeordneter Flutelektroden und Absaugen des durch die Löcher im Behandlungsgut hindurchgetretenen Behandlungsmittels mittels auf der anderen Seite des Behandlungssgutes angeordneter, den Flutelektroden gegenüberliegender Saugelektroden erzwungen werden. Mit einer derartigen Anordnung können auch feinste Löcher wirksam mit frischem Behandlungsmittel durchströmt werden.

In einer bevorzugten Ausführungsform der Erfindung wird das Behandlungsgut in horizontaler Lage erfaßt und in horizontaler Richtung transportiert. Hierfür geeignete Horizontalanlagen werden insbesondere für die Behandlung von Leiterplatten eingesetzt.

Die Elektroden können sowohl zum Metallisieren des Behandlungsgutes als auch zum Ätzen, vorzugsweise zum Entmetallisieren, verwendet werden. Es ist auch eine Kombination der beiden Verfahrensweisen möglich. Beispielsweise kann das Behandlungsgut in Anlagen zum Metallisieren an mehreren in Transportrichtung hintereinander angeordneten und abwechselnd anodisch oder kathodisch gegenüber dem Behandlungsgut polarisierten Elektroden vorbeigeführt werden, so daß das Behandlungsgut jeweils metallisiert und teilweise wieder entmetallisiert wird. Damit das Behandlungsgut am Ende des Transportweges mit einer Metallschicht belegt ist, ist es natürlich erforderlich, die Behandlungsbedingungen so einzustellen, daß die Menge des abgeschiedenen Metalls größer ist als die Menge des im Entmetallisierungsvorgang wieder entfernten Metalls.

Eine für die Durchführung des erfindungsgemäßen Verfahrens geeignete Vorrichtung enthält neben den als Anoden oder Kathoden gegenüber dem Behandlungsgut polarisierbaren Elektroden eine Stromversorgung für die Elektroden und das Behandlungsgut sowie einen Drehantrieb für die Elektroden. Ferner sind Mittel zur Zuführung von Behandlungsmittel zu den Flutelektroden und geeignete Öffnungen in den Flutelektroden, aus denen das Behandlungsmittel ausströmt, oder Mittel zum Zuführen von Behandlungsmittel zu den Oberflächen des Behandlungsgutes und weitere Mittel zum Absaugen des Behandlungsmittels durch Öffnungen in den Saugelektroden vorgesehen. Die Vorrichtung umfaßt ferner Mittel zum linearen Bewegen des Behandlungsgutes und der Elektroden relativ zueinander und einen Vorratsbehälter für das Behandlungsmittel. Erfindungsgemäß sind Mittel zum Einstellen der Drehgeschwindigkeit und -richtung der Elektroden in der Weise vorgesehen, daß die Außenseiten der Elektroden gegenüber den Oberflächen des Behandlungsgutes synchron bewegbar sind, also keine "wischende" Relativbewegung entsteht.

Gemäß einer bevorzugten Ausführungsform der Erfindung sind die Elektroden so ausgebildet, daß sie das Behandlungsgut in horizontaler Lage erfassen und in horizontaler Richtung in der Behandlungsanlage transportieren. Insbesondere geeignet sind langgestreckte, quer zur Richtung der Bewegungsbahn des Behandlungsgutes angeordnete Elektroden, die walzenförmig sind.

Die Elektrode weist neben einer Stromzuführung und einem Drehantrieb ein drehbar gelagertes äußeres Elektrodenrohr mit Öffnungen zur Zu- oder Abführung für das Behandlungsmittel auf. Die Öffnungen am Elektrodenrohr sind am gesamten Umfang vorgesehen. Das Elektrodenrohr dient als vorzugsweise unlösliche Anode oder Kathode und zugleich als Transport- und Führungswalze für das Behandlungsgut, wenn die Elektrode in direktem Kontakt mit dem Behandlungsgut steht. Das Elektrodenrohr wird durch den Drehantrieb in Rotation versetzt und transportiert das Behandlungsgut durch die Anlage.

Zur Isolierung des Elektrodenrohres von den Oberflächen des Behandlungsgutes sind an den Außenseiten der Elektroden flüssigkeits- und ionendurchlässige, elektrisch nichtleitende Distanzmittel vorgesehen. Zwischen diesen und dem Elektrodenrohr sind in einer weiteren bevorzugten Ausführungsform der Erfindung allseitig umfassende und fest anliegende metallische oder textile Gewebe oder Gitter angebracht. Diese dienen dazu, den aus den Öffnungen des Elektrodenrohres austretenden Behandlungsmittelstrahl zu verbreitern bzw. das Behandlungsmittel aus einem größeren Bereich auf der Oberfläche des Behandlungsgutes ins Innere der Elektroden hineinzusaugen.

Im Elektrodenrohr ist ein nicht drehbares Elektrolytrohr vorgesehen, in dem sich in einer Ausführungsform der Erfindung Öffnungen nur auf der der Oberfläche des Behandlungsgutes gegenüberliegenden Mantellinie befinden. Dadurch kann die Oberfläche des Behandlungsgutes gezielt angeströmt werden. Das Elektrolytrohr ist an eine flexible Leitung zur Zu- bzw. Abführung für das Behandlungsmittel an den Behandlungsmittelkreislauf und den Vorratsbehälter für das Behandlungsmittel angeschlossen.

In einer weiteren Ausführungsform der Erfindung ist kein Elektrolytrohr im Elektrodenrohr vorgesehen. Um in diesem Fall eine gezielte Anströmung der Stelle an der Oberfläche des Behandlungsgutes zu erreichen, die der Elektrode direkt gegenüberliegt, ist eine schalenförmige Abdeckung über dem Elektrodenrohr vorgesehen, das lediglich gegenüber der Oberfläche des Behandlungsgutes nach außen hin geöffnet ist. Zwischen der Abdeckung und dem Elektrodenrohr befindet sich ein Spalt.

Um beide Seiten eines plattenförmigen Behandlungsgutes gleichzeitig bearbeiten zu können, sind auf beiden Seiten Elektroden angeordnet. Handelt es sich hierbei um die gemäß der Erfindung ausgebildeten Elektroden, so können beide Oberflächen gleichzeitig mit dem erfindungsgemäßen Verfahren behandelt werden. Es genügt, wenn nur die Elektroden auf der einen Seite des Behandlungsgutes mit einem Drehantrieb versehen sind, während die diesen gegenüberliegenden auf der anderen Seite des Behandlungsgutes angeordneten Elektroden keinen eigenen Antrieb aufweisen, sondern lediglich den Druck der Transportelektroden aufnehmen und durch die Kontaktreibung von dem in Bewegung gesetzten Behandlungsgut mitgenommen werden. Sowohl auf der einen Seite als auch auf der anderen Seite des Behandlungsgutes können die Elektroden in dichter Folge nebeneinander angeordnet werden, so daß nur kurze Behandlungswege für einen vorgegebenen Behandlungsumfang (beispielsweise Schichtdicke der abgeschiedenen Metallschicht, Ätztiefe) erforderlich sind. Die Abstände zwischen zwei aufeinanderfolgenden Elektroden können bis auf einen kleinen isolierenden Zwischenraum verringert werden.

Im Falle einer Horizontalanlage für die Behandlung von Leiterplatten werden walzenförmige Elektroden auf beiden Seiten des Behandlungsgutes angeordnet. Auf der einen Seite, vorzugsweise unten, werden die Elektroden und Gegenwalzen über einen Antrieb in Drehung versetzt, während sich an der oberen Seite des Behandlungsgutes befindende Gegenwalzen und Elektroden durch das Behandlungsgut in Drehung versetzt werden.

Das Behandlungsgut durchläuft die Anlage zwischen den unteren und den oberen Walzen. Den auf der einen Seite angeordneten Elektroden können die auf der unteren Seite des Behandlungsgutes angeordneten Elektroden direkt gegenüber liegen oder auch gegenüber diesen versetzt angeordnet sein. Beispielsweise kann je einer angetriebenen Elektrode eine gleich große nichtangetriebene Elektrode direkt gegenüberliegen oder zwei im Durchmesser kleiner gehaltene Elektroden gegen die obere versetzt angeordnet sein. Es kann auch eine nichtangetriebene Elektrode versetzt gegen je eine gleich große angetriebene Elektrode vorgesehen sein. In den letzten beiden Fällen werden die Löcher im Behandlungsgut unterhalb bzw. oberhalb der Flutelektroden zur besseren Durchströmung offengehalten.

Eine besonders bevorzugte Ausführungsform ergibt sich, wenn sich auf der einen Seite des Behandlungsgutes Flutelektroden und diesen gegenüberliegende auf der anderen Seite des Behandlungsgutes angeordnete Saugelektroden vorgesehen sind. Dies hat den Vorteil, daß das Behandlungsmittel wirksam auch durch feinste Löcher im Behandlungsgut hindurchgefördert wird. In diesem Fall ist kein weiteres Transportmittel auf der den angetriebenen Elektroden gegenüberliegenden Seite des Behandlungsgutes erforderlich.

Alle angegebenen Konfigurationen sind auch mit geeigneten Gegenwalzen, die auf der den Flut- oder Saugelektroden gegenüberliegenden Seite des Behandlungsgutes angeordnet sind und die nicht als Flut- oder Saugelektroden ausgebildet sind, möglich.

In weiteren Ausführungsformen können einige der Walzen lediglich zum Transport und zur Anströmung des Behandlungsgutes eingesetzt werden, ohne daß sie an die Stromversorgung angeschlossen sind. Diese Walzen können elektrisch nichtleitend aufgebaut sein. Insbesondere für dünne Leiterfolien, deren Transport und Führung durch die Behandlungsanlage üblicherweise Schwierigkeiten bereitet, kann eine Kombination von Flut- und Saugelektroden zusammen mit nicht an die Stromversorgung angeschlossenen Transport- und Anströmwalzen vorgesehen sein, wobei sich die Flut- und Saugelektroden wechselseitig gegenüberliegen und auf beiden Seiten des Behandlungsgutes alternierend angeordnet sind.

Anhand der schematischen Figuren 1 bis 11 wird bei erfindungsgemäßen Vorrichtungen die Erfindung beispielhaft dargestellt. Es zeigen:
- Figur 1:: eine Flutelektrode mit axial angeordnetem Elektrolytrohr im Längsschnitt ;
- Figur 2:: die Flutelektrode nach Figur 1 im Querschnitt;
- Figur 3:: eine Flutelektrode mit nichtaxialem Elektrolytrohr im Längsschnitt;
- Figur 4:: die Flutelektrode nach Figur 3 im Querschnitt;
- Figur 5:: eine einteilige Flutelektrode im Längsschnitt;
- Figur 6:: die Flutelektrode nach Figur 5 im Querschnitt;
- Figur 7:: eine Anordnung von Elektroden und Gegenwalzen entlang der Transportbahn des Behandlungsgutes;
- Figur 8:: eine Anordnung von Elektroden und zu diesen versetzt angeordnete Gegenwalzen entlang der Transportbahn des Behandlungsgutes;
- Figur 9:: eine Anordnung von Elektroden- und Gegenwalzenpaaren entlang der Transportbahn des Behandlungsgutes;
- Figur 10:: eine Anordnung von Flutelektroden und diesen gegenüberliegenden Saugelektroden entlang der Transportbahn des Behandlungsgutes;
- Figur 11:: elektrische Schaltungsanordnung für eine elektrolytische Ätzanlage.

In den Figuren ist eine mit Löchern versehene Leiterplatte als Behandlungsgut dargestellt.

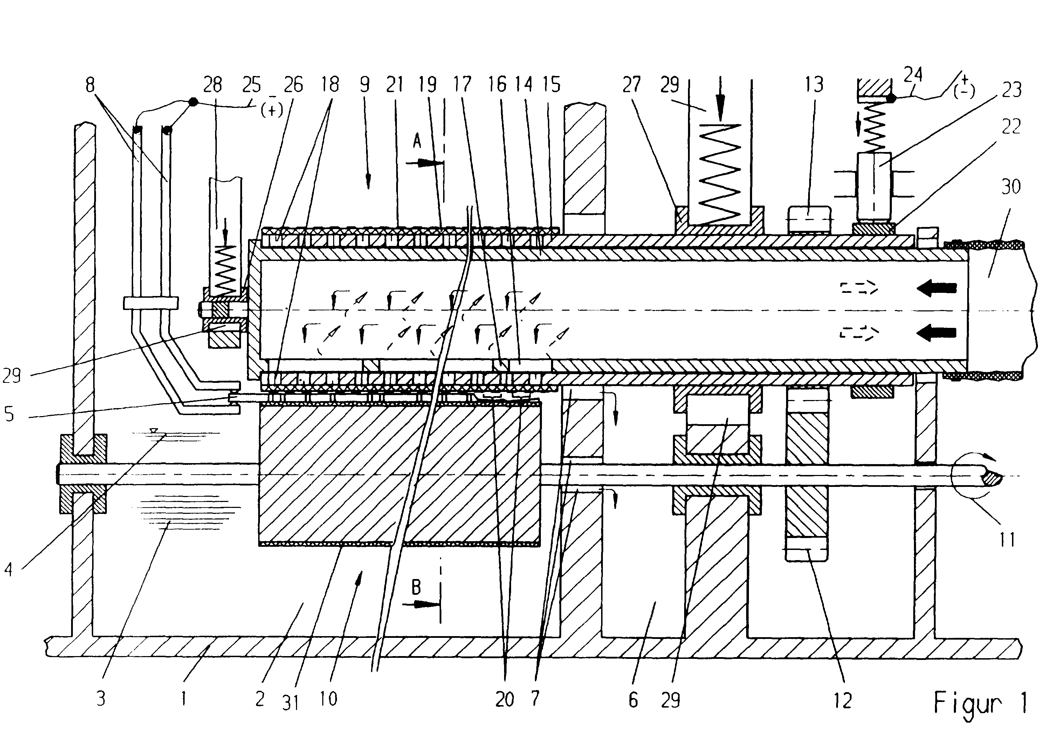

In Figur 1 ist eine mit dem Behandlungsgut 5 in direktem Kontakt stehende Flutelektrode 9 und eine dieser gegenüberliegende, nicht der Zuführung von Behandlungsmittel zur Oberfläche des Behandlungsgutes und der Stromzuführung dienende, Gegenwalze 10 dargestellt. Diese Anordnung kann beispielsweise in eine horizontale Durchlaufanlage eingebaut werden. Aus Gründen der Vereinfachung der Darstellung ist der Arbeitsbereich, in dem sich die Leiterplatte befindet, verkürzt dargestellt.

Das Gehäuse der Durchlaufanlage ist mit 1 bezeichnet. Im Arbeitsbehälter 2 befindet sich ein flüssiges Behandlungsmittel 3, beispielsweise eine Metallisierungs- oder Ätzlösung. Bei Verwendung einer Flutelektrode kann sich das Niveau 4 des flüssigen Behandlungsmittels unterhalb der Ebene des Behandlungsgutes befinden. Werden dagegen Saugelektroden eingesetzt, so muß das Niveau des Behandlungsmittels so hoch eingestellt werden, daß es über der Ansaugöffnung bzw. dem Behandlungsgut steht, damit das Ansaugen von Luft vermieden wird. Der Raum 6 dient als Überlaufabteil für das flüssige Behandlungsmittel. Daher sind in diesem Bereich keine aufwendigen Abdichtungen gegen das Abfließen von Flüssigkeit erforderlich (Öffnungen 7).

Das Behandlungsgut wird von mehreren Klammern 8 seitlich gegriffen und elektrisch kontaktiert. Mehrere Klammern sind entlang der Transportbahn, senkrecht zur Zeichenebene, angeordnet. Die Klammern bewegen sich in der Richtung des Transportweges mit einer Geschwindigkeit, die gleichzeitig die Transportgeschwindigkeit des Behandlungsgutes ist.

Die Umfangsgeschwindigkeit der Flutelektrode und ihrer Gegenwalze sind gleich groß, so daß diese auf dem Behandlungsgut abrollen. Ein Schlupf zwischen der Oberfläche des Behandlungsgutes und den Walzenoberflächen wird vermieden. Dadurch kann es nicht zu Beschädigungen der Oberfläche führen. Gleiche Geschwindigkeiten für die einzelnen Anordnungen werden durch Synchronisation des nicht in Einzelheiten dargestellten Antriebes 11 der Gegenwalze mit dem Antrieb der Klammern sowie durch Übertragung der Rotation der Gegenwalzen über die Zahnräder 12 und 13 auf die Flutelektrode erreicht. Das Zahnradübersetzungsverhältnis ist den Durchmessern der Flutelektrode und der Gegenwalze angepaßt. Insbesondere bei Gegenwalzen mit kleinerem Durchmesser kann der Antrieb 11 für die Walzen auch auf das Zahnrad 13 wirken und von dort auf das Zahnrad 12 übertragen werden.

Die Flutelektrode besteht aus dem Elektrolytrohr 14, das gegen Rotation gesichert gelagert ist, sowie einem rotierenden Elektrodenrohr 15. Das Elektrolytrohr hat an der dem Behandlungsgut zugewandten Mantellinie Öffnungen 16. Dies können Schlitze sein, die durch Stege 17 voneinander getrennt sind. Auch Löcher sind geeignet. Durch diese Öffnungen strömt Elektrolyt aus dem Elektrolytrohr zur Behandlungsstelle an die Oberfläche des Behandlungsgutes. Bei einer Saugelektrode fließt das flüssige Behandlungsmittel von der Behandlungssstelle in das Elektrolytrohr.

Die Menge des austauschbaren Behandlungsmittels und dessen Fließgeschwindigkeit kann durch die Größe der Öffnungen 16, sowie durch den Pumpendruck im Behandlungsmittelkreislauf in weiten Grenzen verändert werden. Die für die Anwendung hoher Stromdichten erforderlichen großen Behandlungsmittelgeschwindigkeiten sind somit leicht erreichbar.

Frisches Behandlungsmittel kann in ausreichender Menge an die Stelle auf der Oberfläche des Behandlungsgutes herangeführt werden, an der die größte Stromdichte herrscht. Vorteilhaft ist, daß das Behandlungsmittel nahezu senkrecht auf die ebene Behandlungsgutoberfläche gefördert wird, so daß die im Behandlungsgut vorgesehenen Löcher mit frischem Behandlungsmittel durchströmt werden.

Das Elektrodenrohr 15 ist auf dem Elektrolytrohr 14 drehbar gelagert. Das vorzugsweise metallische Elektrodenrohr ist zumindest im Arbeitsbereich auf dem gesamten Umfang mit Durchbrüchen 18 versehen. Jeweils durch die Durchbrüche, die sich gerade vor den Öffnungen 16 des Elektrolytrohres befinden, strömt daher Behandlungsmittel zum Behandlungsgut hin oder wird von diesem in die Elektrode hineingesaugt. Dieser Flüssigkeitsstrom kann durch ein metallisches oder textiles Gewebe oder Gitter 19 über dem Elektrodenrohr auch in die Oberflächenbereiche 20, die sich nicht unmittelbar vor den Durchbrüchen 18 befinden, geleitet werden. Der Überzug 19 erzeugt ferner eine gleichmäßig elektrisch leitende Elektrodenoberfläche und gleicht die ungleichmäßige elektrische Feldlinienverteilung von der mit den Durchbrüchen 18 versehenen Elektrodenrohroberfläche zur Oberfläche des Behandlungsgutes aus, da der Durchmesser der Durchbrüche 18 wesentlich größer ist, als die Maschenweite des Gewebes 19. Dies ist besonders wichtig, wenn das Behandlungsgut wie in der gezeigten Anordnung in sehr geringem Abstand von der elektrisch leitenden Elektrodenoberfläche angeordnet und mit hohen Stromdichten elektrolytisch behandelt wird. Auch durch die Drehung des Elektrodenrohres, zusammen mit dem darüber befindlichen Gewebe, wird das Behandlungsmittel im Bereich der Behandlungsstelle gleichmäßig verteilt.

Um einen Kurzschluß zwischen der Elektrode und der Oberfläche des Behandlungsgutes zu vermeiden, ist auf der Elektrodenoberfläche ein Isoliermittel 21 vorgesehen. Soweit dieses die Elektrodenoberfläche nicht nur teilweise bedeckt, muß es flüssigkeits- und ionendurchlässig sein. Beispielsweise können auf den äußersten Erhebungen des Gewebes 19 keramische Partikel durch Plasmabeschichtung aufgetragen werden. Diese sind sehr dünn sowie haft- und abriebfest, was zu einer langen Standzeit führt. Dieser zusätzliche Überzug steht in direktem Kontakt mit der Oberfläche des Behandlungsgutes. Ein direkter Kontakt der metallischen Oberflächen der Elektrode mit den Oberflächen des Behandlungsgutes wird dadurch vermieden. Durch den direkten Kontakt und den Drehantrieb der Elektrode sowie durch die lineare Bewegung der Klammern 8 wird das Behandlungsgut durch die Behandlungsanlage hindurchtransportiert.

Als weitere Isoliermittel 21 können auch Kunststoffringe über dem metallischen Gewebe angeordnet sein, partielle Kunststoffbeschichtungen oder textile Gewebe, jeweils mit oder ohne eine verschleißfreie Keramikbeschichtung. Auch Kombinationen dieser Isoliermittel sind möglich.

Die Metallteile der Elektrode sind im Behandlungsmittel unlöslich. Als Werkstoffe kommen beispielsweise Edelstahl und Titan mit oder ohne eine Beschichtung aus Edelmetallen oder deren Oxide in Frage.

Zur Stromversorgung wird die Elektrode elektrisch kontaktiert, wobei es ausreichend ist, nur das Elektrodenrohr und/oder das metallische Gewebe an die nicht dargestellte Stromversorgung anzuschließen. Mit Ausnahme der Stromzuführung, dem Elektrodenrohr und gegebenenfalls dem metallischen Gewebe über dem Elektrodenrohr können alle übrigen Teile der Elektrode aus elektrisch nichtleitendem Werkstoff gefertigt werden. Zur Stromzuführung sind die elektrisch leitenden Teile mit einem Schleifring 22 elektrisch leitend verbunden. Auf dem Schleifring gleitet ein gefederter Kontakt 23, der die Verbindung über eine elektrische Leitung 24 zur Stromversorgung herstellt. Der Gegenpol dieser Stromversorgung ist über die Leitung 25 und nicht dargestellte Schleifkontakte an die Klammern 8 angeschlossen, mit denen das Behandlungsgut kontaktiert wird. Beim elektrolytischen Metallisieren wird das Behandlungsgut kathodisch und die Elektrode anodisch geschaltet. Beim elektrolytischen Ätzen wird das Behandlungsgut anodisch und die Elektrode kathodisch geschaltet.

Üblicherweise werden verschieden dicke Werkstücke des Behandlungsgutes bearbeitet. Daher muß der Abstand zwischen der Elektrodenoberfläche und der Gegenwalze variabel sein. Vorzugsweise ist die Gegenwalze fest gelagert und der Höhenlage der Klammern 8 angepaßt. Dasselbe gilt für unterhalb des Behandlungsgutes angeordnete Elektroden. Die Aufnahme 26 und das Gleitlager 27 können eine kleine Hubbewegung gegen den Druck von Federn nach oben ausführen. Hierzu ist die Elektrode verdrehungssicher in schlitzförmigen Führungen 28 und 29 gehalten. Die Zahnräder 12 und 13 weisen eine Verzahnung auf, die den Hub zulassen, ohne den Eingriff zu verlieren. Auch der Kontakt 23 kann diesen Hub gegen eine Federkraft ausführen. Schließlich ist auch der Anschluß 30 für die Zu- oder Abführung des Behandlungmittels so flexibel ausgeführt, daß der Hub der Elektrode zum Ausgleich der Dicke des Behandlungsgutes nicht behindert wird.

Die Gegenwalze 10 besteht zweckmäßigerweise aus einem nichtleitenden Werkstoff. Sie kann jedoch auch aus einem Metall mit einem nichtleitenden Überzug 31 ausgeführt sein. Der Überzug 31 ist vorzugsweise flüssigkeitsdurchlässig, um das Durchströmen der Löcher des Behandlungsgutes nicht zu behindern. In ähnlicher Weise wirkt eine Profilierung an der Oberfläche der Gegenwalze.

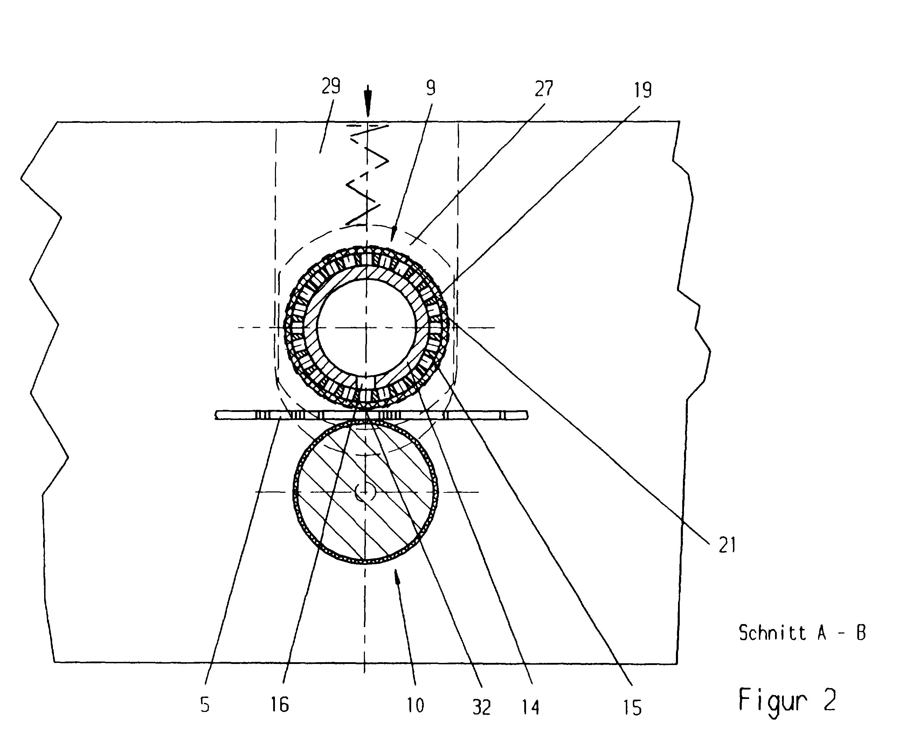

In Figur 2 ist eine Elektrode im Querschnitt entlang der Schnittlinie A-B der Figur 1 gezeigt. Es ist zu erkennen, wie das Lager 27 verdrehungssicher in der Führung 29 zum Hubausgleich gehalten wird. Der Bereich mit der höchsten Stromdichte zwischen der Elektrode und der Oberfläche des Behandlungsgutes liegt an der Mantellinie 32 der Elektrode. Rechts und links davon nimmt die Stromdichte infolge der Zunahme des Anoden-/Kathodenabstandes schnell ab.

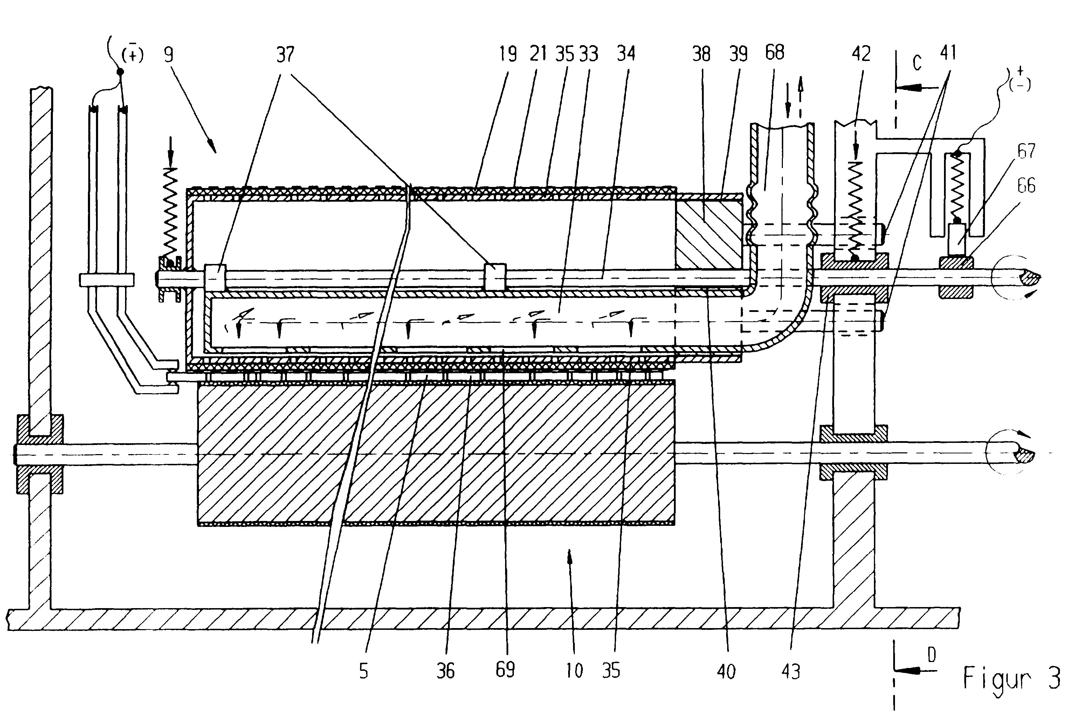

In Figur 3 ist ein weiteres Ausführungsbeispiel, vorzugsweise für Elektroden mit großen Außendurchmessern, gezeigt. Das Elektrolytrohr 33 ist hier exzentrisch zwischen der Achse 34 und dem Elektrodenrohr 35 in dem Bereich angeordnet, der dem Behandlungsgut 5 zugewandt ist. Das Elektrolytrohr stützt sich an den Stellen 37 zur Achse hin ab. Das Elektrodenrohr gleitet an der Lagerstelle 39 auf dem stationären Lagerteil 38. An der Lagerstelle 40 wird die Achse gleitend geführt. Das Lagerteil wird von Stiften 41 gehalten und gegen Verdrehung gesichert.

Die Wand 42 ist geschlitzt. Sie erlaubt der Lagerschale 43 einen Hub zum Dickenausgleich für das Behandlungsgut. Die übrigen Konstruktionselemente entsprechen denen in Figur 1. Daher wird auf die Beschreibung weiterer Einzelheiten verzichtet.

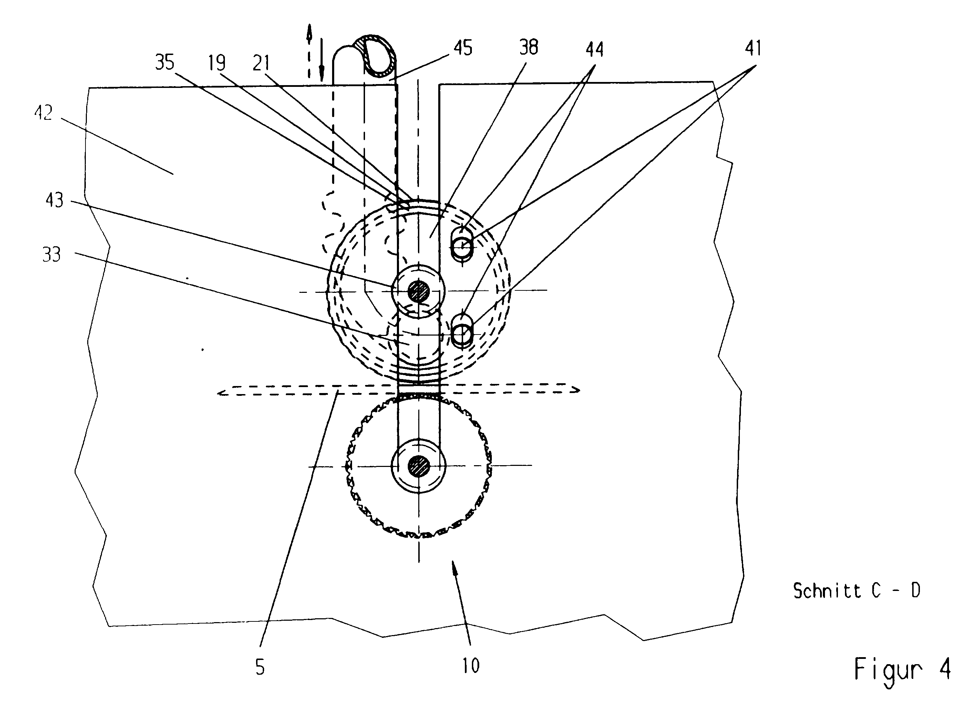

In Figur 4 ist das Ausführungsbeispiel der Figur 3 an der Schnittlinie C-D dargestellt. Die Stifte 41 werden in den Langlöchern 44 geführt, die den Hub der Elektrode zum Ausgleich der Dicke des Behandlungsgutes ermöglichen. Das Behandlungsmittel wird über ein bewegliches Rohr 45 zur Elektrode zu- oder von dieser abgeführt. Das Rohr ist in der Figur beispielhaft nach oben geführt.

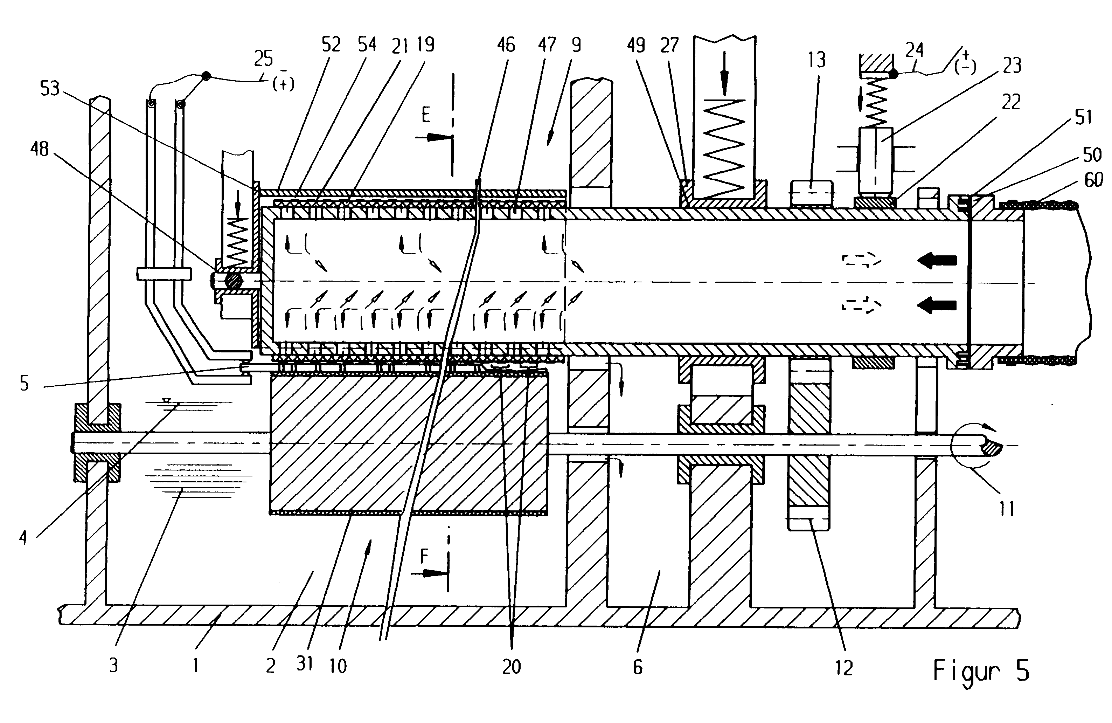

In Figur 5 ist eine einteilige Elektrode gezeigt. Diese besteht lediglich aus einem Elektrodenrohr 46 mit den im Arbeitsbereich auf dem gesamten Umfang des Rohres angebrachten Öffnungen 47. Das Elektrodenrohr ist in den Lagerstellen 48 und 49 drehbar gelagert. Der stationäre, jedoch höhenbewegliche Anschluß 66 für das Behandlungsmittel mündet in das rotierende Elektrodenrohr 46. Über die flüssigkeitsdichte Rotationskupplung 50,51 wird das Behandlungsmittel in die Elektrode hinein oder aus dieser herausgeführt, wobei die Rotationskupplung gleichzeitig auch dazu dient, die Behandlungsmittelführung gegen die Umgebung abzudichten.

Das Ausströmen des Behandlungsmittels aus den auf dem Umfang des Elektrodenrohres verteilten Öffnungen in alle Richtungen wird durch eine über dem Elektrodenrohr angebrachte schalenförmige Abdeckung 52 verhindert. Zwischen beiden Teilen ist ein enger Spalt 54 freigehalten, um zu verhindern, daß sich die Elektrode bei der Drehung an der Abdeckung reibt. Die Abdeckung ist am Lagerteil 53 befestigt und führt dessen Hubbewegungen zum Ausgleich der unterschiedlichen Dicken des Behandlungsgutes mit aus. Zur Behandlungsstelle gerichtet ist die Abdeckung 52 geöffnet. Dadurch kann das Behandlungsmittel gezielt an die Behandlungsstelle auf der Oberfläche des Behandlungsgutes gefördert oder von dieser abgesaugt werden. Diese konstruktive Lösung ist insbesondere bei schmalen Arbeitsbereichen, das heißt bei kurzen Elektroden vorteilhaft anwendbar. Die übrigen konstruktiven Elemente wurden bereits anhand der Figur 1 beschrieben.

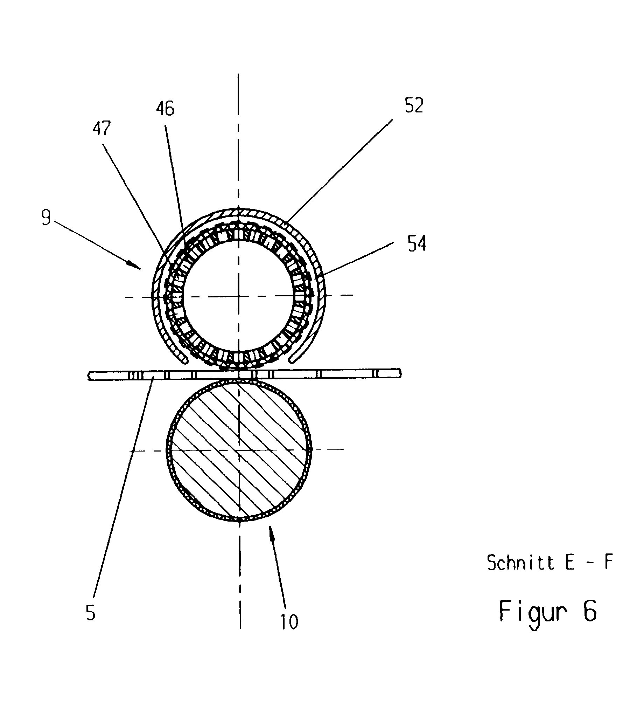

In Figur 6 ist die in Figur 5 dargestellte Anordnung im Querschnitt entlang der Linie E-F dargestellt. Die Abdeckung 52 verhindert das Aus- oder Eintreten des Behandlungsmittels am überwiegenden Teil des Umfanges der Elektrode. Je kleiner der Spalt 54 ist, desto wirksamer ist die Anströmung der Oberfläche des Behandlungsgutes.

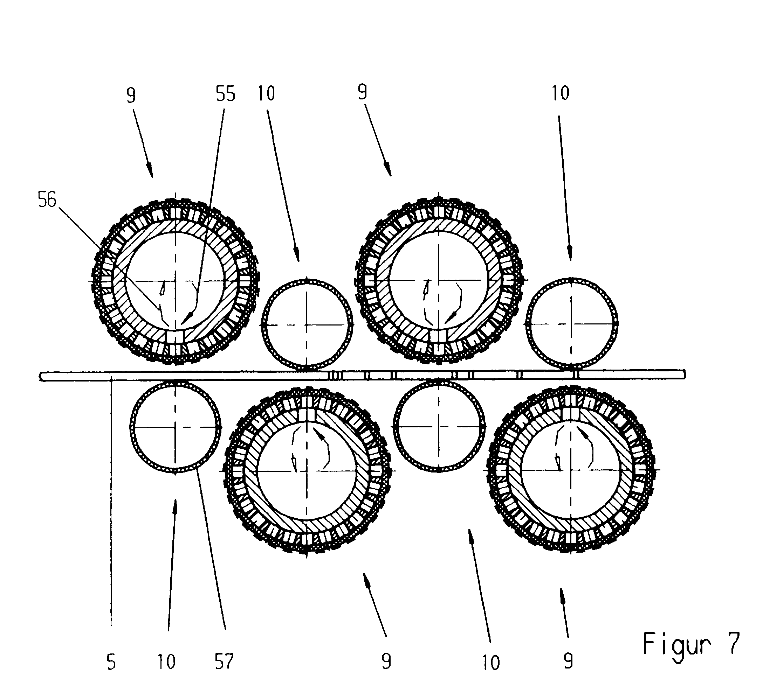

In den Figuren 7 bis 10 sind verschiedene Anordnungen von Elektroden und Gegenwalzen entlang der Transportbahn des Behandlungsgutes in horizontalen Durchlaufanlagen dargestellt.
Im allgemeinen ist plattenförmiges Behandlungsgut, wie beispielsweise Leiterplatten, auf beiden Seiten in gleicher Weise zu behandeln. Daher sind die Anordnungen an der Ober- und Unterseite des Behandlungsgutes gleich aufgebaut. Die eingezeichneten Pfeile geben die Strömungsrichtung des Behandlungsmittels an. Die ausgezogen gezeichneten Pfeile 55 gelten für Flutelektroden, aus denen das Behandlungsmittel auf die Oberfläche des Behandlungsgutes und deren Löcher gefördert wird, die hohl gezeichneten Pfeile 56 für Saugelektroden, mit denen das Behandlungsmittel von den Oberflächen des Behandlungsgutes abgesaugt wird, so daß eine Strömung des Behandlungsmittels zur Behandlungsstelle zwischen der Elektrode und der Oberfläche des Behandlungsgutes entsteht.

In Figur 7 sind die Elektroden 9 und ihre Gegenwalzen 10 einander genau gegenüberliegend angeordnet. Die Elektroden halten einen festen Abstand gegenüber der Oberfläche des Behandlungsgutes ein. In diesem Fall ist es nicht erforderlich, daß diese und die unteren Gegenwalzen eine Hubbewegung ausführen. Für die oberen Gegenwalzen ist die Hubbewegung für den Ausgleich der Dicke des Behandlungsgutes jedoch vorgesehen. Zweckmäßig ist es, wenn die Gegenwalzen mit einer flüssigkeitsdurchlässigen Oberfläche 57 versehen sind.

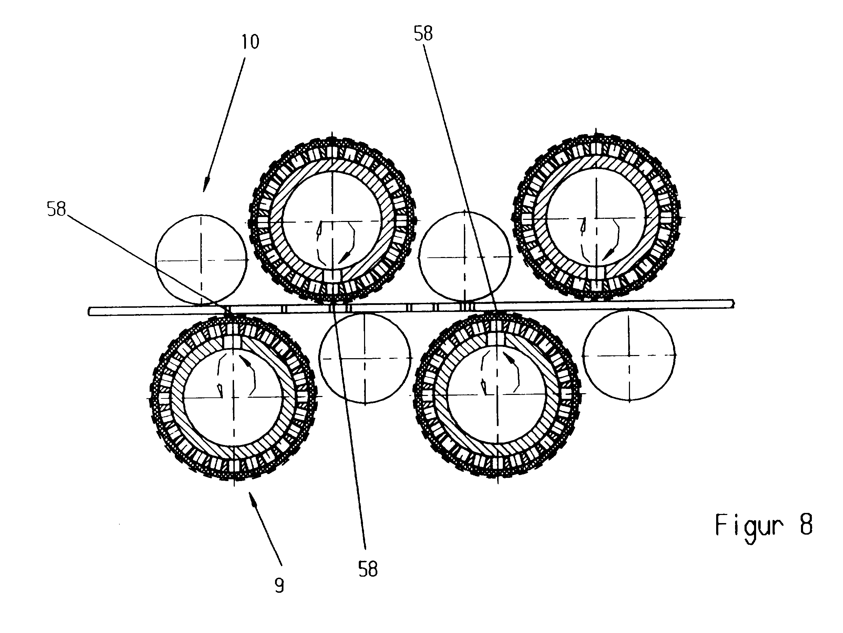

In Figur 8 sind die Gegenwalzen zu den auf dem Behandlungsgut abrollenden Elektroden versetzt so angeordnet, so daß im Bereich 58 an der Kontaktstelle zwischen der Elektrode und der Oberfläche des Behandlungsgutes Behandlungsmittel ungehindert aus der Elektrode aus- bzw. in diese hineinströmen kann. Durch die versetzte Anordnung wird auch die Lochdurchflutung unterstützt. Eine flüssigkeitsdurchlässige Oberfläche der Gegenwalzen kann hier daher entfallen.

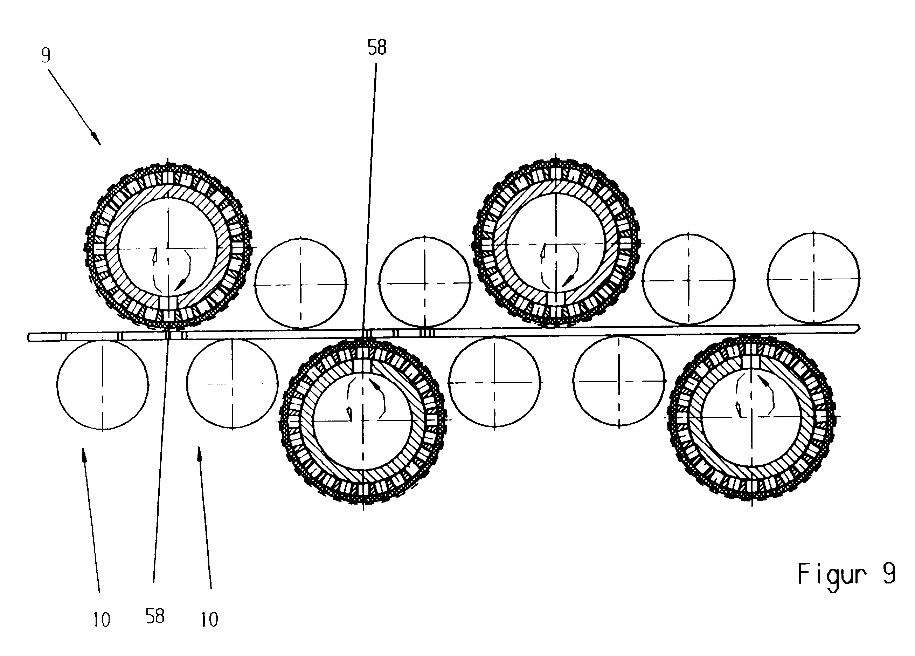

In der Anordnung nach Figur 9 wird der Bereich 58 durch die Verwendung von zwei Gegenwalzen 10 für je eine Elektrode 9 freigehalten. Diese Anordnung hat den Vorteil, daß dünnes Behandlungsgut, wie beispielsweise Leiterfolien, sehr gut durch die Behandlungsanlage hindurchgeführt werden können.

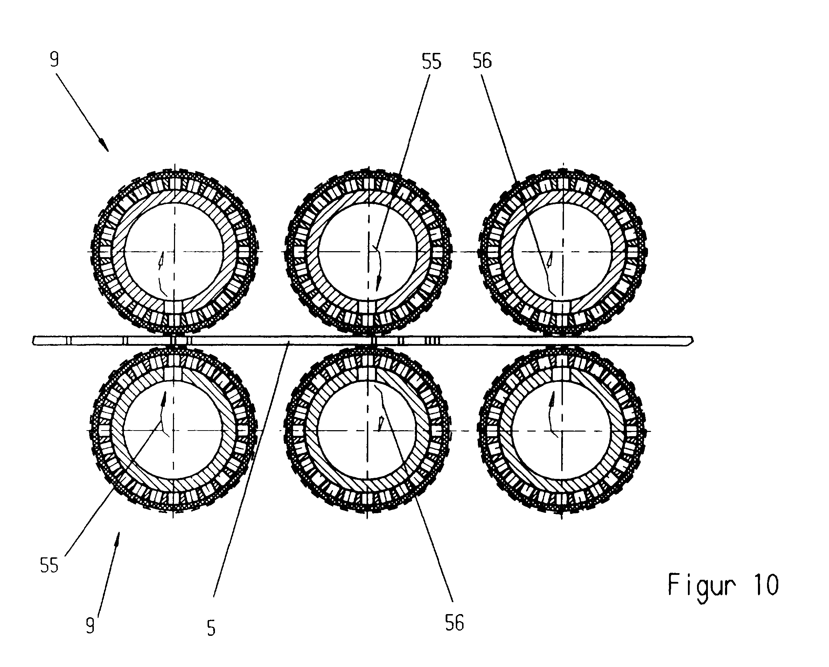

Bei der in Figur 10 dargestellten Anordnung sind keine Gegenwalzen vorgesehen. Je eine Flutelektrode und eine Saugelektrode sind zur besseren Lochdurchflutung einander gegenüberliegend angeordnet. Entlang der Transportbahn wechseln auf einer Seite Flut- und Saugelektroden ab. Mit dieser Anordnung ist eine sehr dichte Folge von Elektroden möglich, so daß die Länge der Behandlungsanlage sehr kurz gehalten werden kann.

Wird das erfindungsgemäße Verfahren zum elektrolytischen Ätzen beispielsweise von metallischen Oberflächen eingesetzt, so lagern sich auf den metallischen und mit der Stromversorgung verbundenen Metallteilen der Elektroden das vom Behandlungsgut abgetragene Metall ab. Von dort muß es kontinuierlich oder diskontinuierlich wieder abgetragen werden.

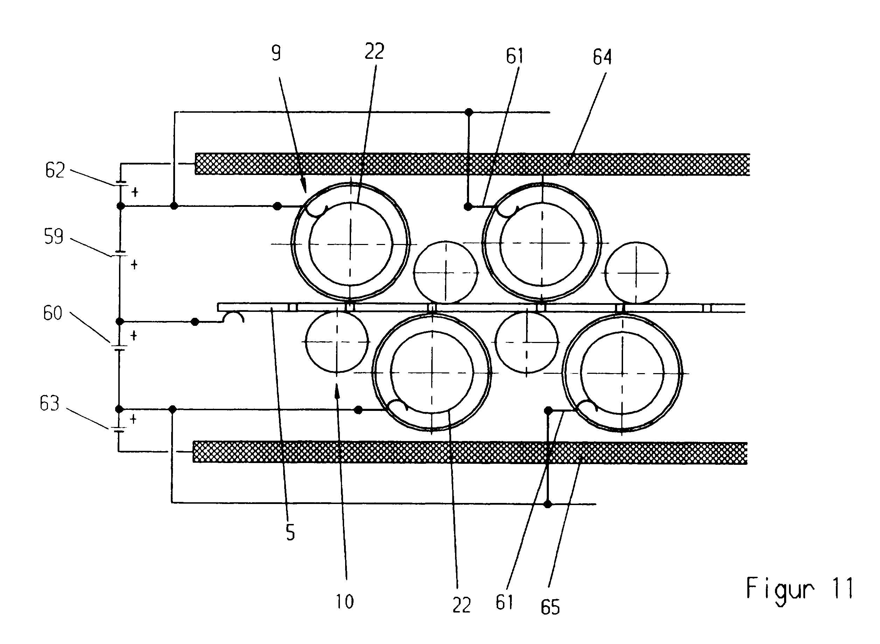

In Figur 11 ist eine hierfür geeignete elektrische Schaltungsanordnung dargestellt. Mit 59 und 60 ist die Stromversorgung für das Ätzverfahren auf der Ober- und Unterseite des Behandlungsgutes 5 bezeichnet. Die Elektroden 9 werden über die Kohlebürsten 61 und Schleifringe 22 elektrisch kontaktiert.

Weitere Stromversorgungsquellen 62 und 63 dienen zum Abtrag des auf den Elektroden abgeschiedenen Metalls und dessen Abscheidung auf den Hilfskathoden 64 und 65, die bedarfsweise ausgetauscht werden können. Die elektrische Kontaktierung der Stromversorgungsquellen 62 und 63 mit den Elektroden wird über dieselben Kontakte wie die der Stromversorgung 59 und 60 verwirklicht.

Die beim elektrolytischen Metallisieren mit unlöslichen Anoden erforderliche Ergänzung der Elektrolytlösung mit den abzuscheidenden Metallionen wird nach bekannten Methoden innerhalb oder außerhalb der elektrolytischen Zelle vorgenommen.

## Patentansprüche

1. Verfahren zum elektrolytischen Metallisieren oder Ätzen von mit Löchern versehenen Leiterplatten mit hoher Stromdichte,
- bei dem die Leiterplatten und walzenförmige Elektroden mit einem Behandlungsmittel in Kontakt gebracht und die Elektroden gegenüber den Leiterplatten elektrisch polarisiert werden,
- wobei diese linear und die Elektroden drehend bewegt werden und den teils hohlen Elektroden Behandlungsmittel zugeführt oder aus diesen abgesaugt wird,
- wobei das Behandlungsmittel aus Öffnungen an den Elektroden, die den Oberflächen der Leiterplatten gegenüberliegen, mittels geeignetem Pumpendruck im Behandlungsmittelkreislauf im wesentlichen senkrecht und gezielt gegen die Oberflächen der Leiterplatten gefördert oder im wesentlichen senkrecht und gezielt von diesen abgesaugt wird, so daß das Behandlungsmittel unter Druck durch die Löcher in den Leiterplatten hindurchgefördert wird
und wobei die Drehgeschwindigkeit und -richtung der Elektroden (9) so eingestellt wird, daß die Außenseiten der Elektroden zu den Oberflächen der Leiterplatten (5) synchron bewegt werden.

2. Verfahren nach Anspruch 1, dadurch gekennzeichnet, daß die Elektroden (9) mit den Leiterplatten (5) in direkten Kontakt gebracht werden.

3. Verfahren nach einem der vorstehenden Ansprüche, dadurch gekennzeichnet, daß das Behandlungsmittel (3) die Löcher in den Leiterplatten (5) zwangsweise durchströmt und zwar mittels auf der einen Seite der Leiterplatten angeordneter Flutelektroden (55), aus denen das Behandlungsmittel durch Öffnungen (16,18) ausströmt, und durch Absaugen mittels auf der anderen Seite der Leiterplatten angeordneter Saugelektroden (56), die das Behandlungsmittel aus den Löchern saugen.

4. Verfahren nach einem der vorstehenden Ansprüche, dadurch gekennzeichnet, daß die Leiterplatten (5) in horizontaler Lage von Klammern erfaßt und in horizontaler Richtung transportiert werden.

5. Verfahren nach einem der vorstehenden Ansprüche zum Metallisieren von Leiterplatten mit einer Metallisierungslösung als Behandlungsmittel, bei dem die Leiterplatten an mehreren in Transportrichtung hintereinander angeordneten Elektroden vorbeigeführt werden, dadurch gekennzeichnet, daß
- die Elektroden (9) abwechselnd anodisch oder kathodisch gegenüber den Leiterplatten polarisiert werden und
- daß die an den Elektroden vorbeigeführten Leiterplatten (5) dadurch jeweils metallisiert und teilweise wieder entmetallisiert werden.

6. Vorrichtung zum elektrolytischen Metallisieren oder Ätzen von mit Löchern versehenen Leiterplatten, umfassend
- als Anoden oder Kathoden gegenüber den Leiterplatten (5) polarisierbare hohle, walzenförmige Elektroden (9), eine Stromversorgung für die Elektroden und die Leiterplatten sowie einen Drehantrieb (11) für die Elektroden,
- Mittel zum Zuführen von Behandlungsmittel (3) zu den hohlen Elektroden und Öffnungen (18,47) in den Elektroden, aus denen das Behandlungsmittel ausströmt, oder Mittel zum Zuführen von Behandlungsmittel zu den Oberflächen der Leiterplatten und weitere Mittel zum Absaugen des Behandlungsmittels durch Öffnungen in den Elektroden, wobei ferner die Elektroden derart ausgebildet sind oder mit solchen zusätzlichen Mitteln versehen sind, daß das Behandlungsmittel im wesentlichen senkrecht und gezielt an die Oberflächen der Leiterplatten gefördert oder von diesen abgesaugt werden kann, so daß das Behandlungsmittel unter Druck durch die Löcher in den Leiterplatten hindurchgefördert wird,
- Mittel (11,12,13) zum Einstellen einer solchen Drehgeschwindigkeit und -richtung der Elektroden, daß die Außenseiten der Elektroden (9) gegenüber den Oberflächen der Leiterplatten synchron bewegbar sind und
- Vorratsbehälter für das Behandlungsmittel.

7. Vorrichtung nach Anspruch 6, dadurch gekennzeichnet, daß die Elektroden (9) so angeordnet sind, daß sie in direktem Kontakt mit den Leiterplatten (5) stehen.

8. Vorrichtung nach einem der Ansprüche 6 oder 7, gekennzeichnet durch langgestreckte quer zur Richtung der Bewegungsbahn der Leiterplatten (5) angeordnete Elektroden (9), umfassend ein drehbares Elektrodenrohr (15,35,46) mit Öffnungen (18,47) und eine flexible Zu- oder Abführung (30) für das Behandlungsmittel (3) zur Elektrode, wobei eine schalenförmige, nur zur Leiterplatte (5) hin geöffnete Abdeckung (52) das Elektrodenrohr (46) umgibt.

9. Vorrichtung nach einem der Ansprüche 6 oder 7, dadurch gekennzeichnet, daß in einem nicht drehbaren, im Elektrodenrohr (15,35,46) angeordneten Elektrolytrohr (14,33) der Oberfläche der Leiterplatten (5) gegenüberliegende Öffnungen (16) vorgesehen sind.

10. Vorrichtung nach einem der Ansprüche 6 bis 9, gekennzeichnet durch an den Außenseiten der Elektroden (9) angebrachte flüssigkeits- und ionendurchlässige elektrisch nichtleitende Distanzmittel (21).

11. Vorrichtung nach einem der Ansprüche 6 bis 10, gekennzeichnet durch ein das Elektrodenrohr (15,35,46) allseitig umfassendes und festanliegendes metallisches oder textiles Gewebe oder Gitter (19).

12. Vorrichtung nach einem der Ansprüche 6 bis 11, gekennzeichnet durch einer Seite einer Leiterplatte (5) gegenüberliegende Elektroden (9) und weitere auf der anderen Seite der Leiterplatte angeordnete Elektroden oder Gegenwalzen (10).

13. Vorrichtung nach einem der Ansprüche 6 bis 12, gekennzeichnet durch Flutelektroden (55), mit denen das Behandlungsmittel durch die Löcher in den Leiterplatten (5) hindurchgefördert wird, auf der einen Seite der Leiterplatten und den Flutelektroden gegenüberliegende Saugelektroden (56), in die das durch die Löcher in den Leiterplatten hindurchtretende Behandlungsmittel hineingesaugt wird, auf der anderen Seite der Leiterplatten.

## Claims

1. Method for the electrolytic metallization or etching of printed circuit boards of high current density, which are provided with holes,
- wherein the printed circuit boards and roller-like electrodes are brought into contact with a treatment agent, and the electrodes are electrically polarised relative to the printed circuit boards,
- said printed circuit boards being displaced linearly and the electrodes being rotatingly displaced, and treatment agent being supplied to the partially hollow electrodes or removed by suction therefrom,
- the treatment agent being conveyed from apertures in the electrodes, which are situated opposite the surfaces of the printed circuit boards, by means of suitable pump pressure in the treatment agent circuit substantially vertically and appropriately towards the surfaces of the printed circuit boards or being removed by suction therefrom substantially vertically and appropriately, so that the treatment agent is conveyed under pressure through the holes in the printed circuit boards,
and the rotational speed and direction of the electrodes (9) being so set that the outsides of the electrodes are displaced synchronously relative to the surfaces of the printed circuit boards (5).

2. Method according to claim 1, characterised in that the electrodes (9) are brought into direct contact with the printed circuit boards (5).

3. Method according to one of the preceding claims, characterised in that the treatment agent (3) positively flows through the holes in the printed circuit boards (5), being effected by means of flood electrodes (55), which are disposed on one side of the printed circuit boards and from which the treatment agent flows through apertures (16,18), and by a removal by suction by means of suction electrodes (56), which are disposed on the other side of the printed circuit boards and draw by suction the treatment agent from the holes.

4. Method according to one of the preceding claims, characterised in that the printed circuit boards (5) are gripped in the horizontal position by clamps and conveyed in the horizontal direction.

5. Method, according to one of the preceding claims, for metallizing printed circuit boards with a metallization solution as the treatment agent, wherein the printed circuit boards are guided past a plurality of electrodes, which are disposed one behind the other when viewed with respect to the direction of conveyance, characterised in that
- the electrodes (9) are alternately anodically or cathodically polarised relative to the printed circuit boards, and
- in that the printed circuit boards (5), which are guided past the electrodes, are each thereby metallized and partially demetallized again.

6. Apparatus for the electrolytic metallization or etching of printed circuit boards, which are provided with holes, comprising
- hollow, roller-like electrodes (9), which are polarisable as anodes or cathodes relative to the printed circuit boards (5), a power supply for the electrodes and the printed circuit boards as well as a rotary drive (11) for the electrodes,
- means for supplying treatment agent (3) to the hollow electrodes and apertures (18,47) in the electrodes, from which the treatment agent flows, or means for supplying treatment agent to the surfaces of the printed circuit boards, and additional means for removing by suction the treatment agent through apertures in the electrodes, the electrodes also being so configured or being provided with such additional means that the treatment agent can be conveyed substantially vertically and appropriately to the surfaces of the printed circuit boards or be removed by suction therefrom, so that the treatment agent is conveyed under pressure through the holes in the printed circuit boards,
- means (11,12,13) for setting such a rotational speed and direction for the electrodes that the outsides of the electrodes (9) are displaceable synchronously relative to the surfaces of the printed circuit boards, and
- storage containers for the treatment agent.

7. Apparatus according to claim 6, characterised in that the electrodes (9) are so disposed that they are in direct contact with the printed circuit boards (5).

8. Apparatus according to one of claims 6 or 7, characterised by elongate electrodes (9), which are disposed transversely relative to the direction of the path of displacement of the printed circuit boards (5), comprising a rotatable electrode tube (15,35,46), having apertures (18,47), and a flexible means (30) for feeding or discharging the treatment agent (3) to or from the electrode, a dish-shaped cover (52) which is only open towards the printed circuit board (5) surrounding the electrode tube (46).

9. Apparatus according to one of claims 6 or 7, characterised in that apertures (16), which are situated opposite the surface of the printed circuit boards (5), are provided in a non-rotatable electrolytic tube (14,33) disposed in the electrode tube (15,35,46).

10. Apparatus according to one of claims 6 to 9, characterised by electrically non-conductive spacer means (21), which are mounted on the outsides of the electrodes (9) and are permeable to fluids and ions.

11. Apparatus according to one of claims 6 to 10, characterised by a metallic or textile fabric or lattice (19), which surrounds the electrode tube (15,35,46) in all directions and fixedly abuts thereagainst.

12. Apparatus according to one of claims 6 to 11, characterised by electrodes (9), which are situated opposite one side of a printed circuit board (5), and additional electrodes or counter-rollers (10), which are disposed on the other side of the printed circuit board.

13. Apparatus according to one of claims 6 to 12, characterised by flood electrodes (55), by means of which the treatment agent is conveyed through the holes in the printed circuit boards (5), on one side of the printed circuit boards, and suction electrodes (56), which are situated opposite the flood electrodes, and into which the treatment agent passing through the holes in the printed circuit boards is introduced by suction, on the other side of the printed circuit boards.

## Revendications

1. Procédé de métallisation ou d'attaque électrolytique de circuits imprimés dotés de trous et présentant une forte densité de courant
- dans lequel les circuits imprimés et les électrodes en forme de cylindre sont mis en contact avec un moyen de traitement et dans lequel les électrodes sont polarisées électriquement par rapport aux circuits imprimés,
- ces derniers étant alors déplacés, linéairement et les électrodes, par rotation et le moyen de traitement étant amené aux électrodes en partie creuses ou étant aspiré à partir des dites électrodes,
- le moyen de traitement sortant des ouvertures sur les électrodes situées face aux surfaces des circuits imprimés, étant transporté en substance verticalement et de manière ciblée contre les surfaces des circuits imprimés, à l'aide de la pression de pompage appropriée dans le circuit du moyen de traitement ou étant aspiré en substance verticalement et de manière ciblée par lesdites surfaces des circuits imprimés si bien que le moyen de traitement est transporté sous pression à travers les trous des circuits imprimés
et la vitesse et le sens de rotation des électrodes (9) étant réglés de telle sorte que les côtés extérieurs des électrodes sont déplacés de manière synchrone avec les surfaces des circuits imprimés (5).

2. Procédé selon la revendication 1, caractérisé en ce que les électrodes (9) sont mises en contact direct avec les circuits imprimés (5).

3. Procédé selon l'une quelconque des revendications précédentes, caractérisé en ce que le moyen de traitement (3) traverse obligatoirement les trous des circuits imprimés (5) et pour préciser, à l'aide des électrodes de flux (55) disposées sur l'un des côtés des circuits imprimés et à partir desquelles le moyen de traitement s'écoule par les ouvertures (16, 18), et par aspiration à l'aide des électrodes d'aspiration (56) disposées sur l'autre côté des circuits imprimés et aspirant le moyen de traitement sortant des trous.

4. Procédé selon l'une quelconque des revendications précédentes, caractérisé en ce que les circuits imprimés (5) sont saisis en position horizontale par des pinces et sont transportés dans le sens horizontal.

5. Procédé selon l'une quelconque des revendications précédentes, pour la métallisation de circuits imprimés avec une solution de métallisation en tant que moyen de traitement, dans lequel les circuits imprimés passent devant plusieurs électrodes disposées l'une derrière l'autre dans le sens de transport, caractérisé en ce que
- les électrodes (9) sont polarisées alternativement anodiquement ou cathodiquement par rapport aux circuits imprimés et
- en ce que les circuits imprimés (5) passant devant les électrodes sont, par ce passage, respectivement métallisés et en partie de nouveau démétallisés.

6. Dispositif de métallisation ou d'attaque électrolytique de circuits imprimés dotés de trous, comprenant
- des électrodes (9) en forme de cylindre, creuses et polarisables en tant qu'anodes ou cathodes par rapport aux circuits imprimés (5), une alimentation en courant pour les électrodes et les circuits imprimés ainsi qu'un entraînement à rotation (11) pour les électrodes,
- des moyens pour amener le moyen de traitement (3) vers les électrodes creuses et les ouvertures (18, 47) réalisées dans les électrodes d'où s'écoule le moyen de traitement ou des moyens pour amener le moyen de traitement vers les surfaces des circuits imprimés et d'autres moyens pour aspirer le moyen de traitement par des ouvertures réalisées dans les électrodes, les électrodes étant en plus conçues de telle sorte ou dotées de tels moyens supplémentaires que le moyen de traitement est transporté en substance verticalement et de manière ciblée sur les surfaces des circuits imprimés ou peut être aspiré à partir de ces dernières de telle sorte que le moyen de traitement est transporté sous pression à travers les trous prévus dans les circuits imprimés,
- des moyens (11, 12, 13) pour régler une vitesse et un sens de rotation des électrodes de façon à ce que les côtés extérieurs des électrodes (9) puissent se déplacer de manière synchrone par rapport aux surfaces des circuits imprimés et
- des réservoirs de stockage pour le moyen de traitement.

7. Dispositif selon la revendication 6, caractérisé en ce que les électrodes (9) sont disposées de façon à être en contact direct avec les circuits imprimés (5).

8. Dispositif selon la revendication 6 ou 7, caractérisé par des électrodes (9) disposées dans le sens longitudinal, transversalement par rapport au sens de la trajectoire de déplacement des circuits imprimés (5) comprenant un tube d'électrode rotatif (15, 35, 46) avec des ouvertures (18, 47) et une admission ou évacuation (30) pour le moyen de traitement (3) vers l'électrode, un couvercle (52) en forme de coque et ouvert uniquement vers le circuit imprimé (5) entourant le tube d'électrode (46).

9. Dispositif selon la revendication 6 ou 7, caractérisé en ce que des ouvertures (16) opposées à la surface des circuits imprimés (5) sont prévues dans un tube d'électrolyte (14, 33) non rotatif et disposé dans le tube d'électrode (15, 35, 46).

10. Dispositif selon l'une quelconque des revendications 6 à 9, caractérisé par des moyens d'écartement (21) placés sur les côtés extérieurs des électrodes (9), perméables aux liquides et aux ions et non-électroconducteurs.

11. Dispositif selon l'une quelconque des revendications 6 à 10, caractérisé par un tissu ou treillis métallique (19) ou textile enveloppant le tube d'électrode (15, 35, 46) de tous les côtés et ajusté de manière fixe.

12. Dispositif selon l'une quelconque des revendications 6 à 11, caractérisé par des électrodes (9) opposées à un côté d'un circuit imprimé (5) et d'autres électrodes ou contre-cylindres (10)disposés sur l'autre côté du circuit imprimé.

13. Dispositif selon l'une quelconque des revendications 6 à 12, caractérisé par des électrodes de flux (55) par lesquelles le moyen de traitement est transporté à travers les trous réalisés dans les circuits imprimés (5), sur l'un des côtés des circuits imprimés et par des électrodes d'aspiration (56) face aux électrodes de flux dans lesquelles le moyen de traitement traversant les trous réalisés dans les circuits imprimés est introduit par aspiration, sur l'autre côté des circuits imprimés.
